# EUROPEAN PATENT SPECIFICATION

(11) **EP 2 061 294 B1**
(45) Date of publication and mention of the grant of the patent: **02.02.2011**
(21) Application number: 08162017.1
(22) Date of filing: 07.08.2008
(51) Int. Cl.: H05K 7/02, H05K 5/00

(54) **Electrical junction box to be mounted on a motor vehicle**
Elektroanschlusskasten zur Montage auf einem Kraftfahrzeug
Boîte de raccordement électrique à assembler sur un véhicule à moteur

(30) Priority: 26.10.2007 JP 2007279522
(43) Date of publication of application: 20.05.2009
(73) Proprietor: Sumitomo Wiring Systems, Ltd., Yokkaichi-city, Mie 510-8503 (JP)
(72) Inventor: Kanazawa, Masashi, Yokkaichi-city, Mie Aichi 510-8503 (JP); Sekido, Toshihisa, Yokkaichi-city, Mie Aichi 510-8503 (JP); Higuchi, Eiji, Yokkaichi-city, Mie Aichi 510-8503 (JP)
(74) Representative: Winter, Brandl, Fürniss, Hübner, Röss, Kaiser, Polte - Partnerschaft

(56) References cited:
- EP-A- 1 914 843

## Description

### [Technical Field]

This invention relates to an electrical junction box to be mounted on a motor vehicle and more particularly relates to an electrical junction box that can enhance chemical resistance and improves an attaching structure to a vehicle body.

### [Background Art]

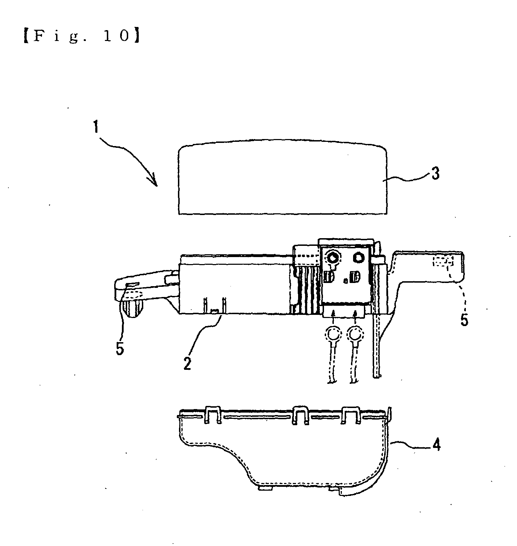

Heretofore, an electrical junction box 1 to be mounted on a vehicle body, shown in Fig. 10, has been generally used. The electrical junction box 1 includes an upper cover 3, a casing body 2, and a lower cover 4. Electrical components such as fuses, relays, or the like are mounted on the casing body 2 and interior circuit members are contained in the casing body 2. The upper and lower covers 3 and 4 are made of a material having high chemical resistance and mounted on upper and lower sides of the casing body 2. A peripheral wall of the casing body 2 in such a kind of the electrical junction box is exposed outward and vehicle body attaching brackets 5 project from an exterior of the peripheral wall so that the brackets are secured to attaching members (not shown) on a vehicle body by bolts. Thus, the electrical junction box 1 is attached to the vehicle body (see JP 2006-81276 A).

On the other hand, the casing body 2 of the electrical junction box 1 is generally made of a material such as a nylon or the like having superior thermal resistance, since the casing body 2 is subject to heat generated from the fuses or the like. However, such material is inferior to chemical resistance. For example, in the case where the electrical junction box 1 is disposed near batteries, a battery electrolyte such as a dilute sulfuric acid may adhere to the peripheral wall of the casing body 2 or the brackets 5 on account of some reasons. Under these conditions, the electrolyte-adhered portions on the casing body or the brackets may be discolored and dissolved. Accordingly, the electrical junction box 1 must be attached to a limited position where the battery electrolyte does not adhere to the casing body 2 and the brackets 5. Thus, it is difficult to freely change the attaching position of the electrical junction box 1 in accordance with a layout in a vehicle body.

In addition, in the case where the electrical junction box is mounted near the batteries in an engine compartment, since the engine compartment is an exposure area to water, cover members are coupled to upper and lower parts of the casing body in view of waterproof, peripheral walls of the cover members are connected to an outer peripheral wall of the casing body, and a waterproof mechanism is provided on the connected portions between the peripheral walls. However, it is difficult to surely prevent water from entering the casing body.

Another problem encountered with known electrical junction boxes is readily to be seen from EP 1 914 843 A1, which constitutes the closest prior art. In the electrical junction box disclosed therein the problem with respect to contradictory needs of protection against chemical corrosion on the one hand and heat resistivity on the other hand is solved by providing an upper and a lower cover or cover halves surrounding or encapsulating a casing body carrying electrical components, wherein the cover halves can be made of corrosion-resistant material and the casing body can be made of heat-resistant material. Accordingly, both needs are satisfied, but this known junction box suffers from the drawback of waste of space insofar as upper and lower cover half are partially plugged within each other at their orifices and connecting means are provided for securing this plugged condition. Both plugging and connecting with the respective constructional means therefore expands the size of the junction box peripherally. This in turn restricts freedom of choice of the attaching position of the electrical junction box, especially in a confined space, e.g. a motor compartment.

### [Problems that the Invention is to solve]

In view of the above problems, an object of the present invention is to provide an electrical junction box that can enhance chemical resistance and a waterproof function and can freely select a vehicle body attaching position in accordance with a layout in a vehicle body.

### [Means for Solving the Problems]

In order to solve this problem, the present invention provides an electrical junction box to be mounted on a motor vehicle, including a casing body that contains interior circuit members, an upper cover, and a lower cover, wherein vehicle body attaching brackets are provided on at least one of said upper and lower covers; wherein said casing body is provided on an exterior with engaging portions and at least one of said upper and lower covers is provided on the peripheral walls thereof with portions being engaged that are locked with said engaging portions; and wherein, when said engaging portions lock said portions being engaged, said upper cover is coupled to said lower cover and said upper and lower covers enclose said casing body. According to the present invention furthermore, when said engaging portions lock said portions being engaged, a lower end of said upper cover contacts an upper end of said lower cover, so that peripheral walls of upper and lower cover are aligned in the plane of a common surface; and said engaging portions are provided at said peripheral walls of upper and lower cover such as not to project from said plane.

As described above, in the electrical junction box of the present invention, since the upper and lower covers enclose the whole exterior of the casing body that contains the interior circuit members, it is possible to protect the casing body from being corroded by chemicals such as a battery electrolyte. By making the upper and lower covers from a material having superior chemical resistance, it is possible to enhance chemical resistance of the whole electrical junction box. Furthermore, in the case where the electrical junction box is mounted on an exposure area to water such as an engine compartment or the like, it is possible to enhance a waterproof function of the electrical junction box.

In order to enclose the casing body by the upper and lower covers, an upper end of the peripheral wall of the lower cover that covers a lower part of the casing body contacts a lower end of the peripheral wall of the upper cover that covers an upper part of the casing body. The upper and lower covers enclose the casing body so that the interiors and exteriors of the peripheral walls of the upper and lower covers accord with each other to form the same surfaces. Since the portions being engaged project from the peripheral walls of the lower cover and/or the upper cover, when the engaging portions on the exterior of the casing body lock the portions being engaged, the engaging portions do not project outward from the covers and, as described above, the exteriors of the peripheral walls of the upper and lower covers can be continued.

Thus, since the upper and lower covers enclose and contain the casing body, it is possible to downsize the electrical junction box itself and to readily attach the electrical junction box to a narrow space such as a space under a seat of a motorcycle.

Also, as described above, since the engaging portions provided on the exterior of the casing body lock the portions being engaged that are provided on one of or both of the peripheral walls of the upper and lower covers, it is possible to position and secure the casing body in and to the covers without causing rattling, thereby preventing any breakage of the casing body due to vibrations.

When the portions being engaged of the lower cover and/or the upper cover are locked on the engaging portions of the casing body, a clearance for thermal expansion is defined between the exteriors of the lower cover and/or the upper cover and the engaging portions of the casing body.

Preferably, in order to surely position and secure the casing body in and to the upper and lower covers, the upper and lower covers may be provided on the peripheral walls with portions being engaged that are locked to the engaging portions on the exteriors of the casing body.

In more detail, for example, it is preferable that the upper and lower covers are provided on the peripheral walls with a plurality of locking frames as the portions being engaged and that the casing body is provided on the exterior at the positions corresponding to the respective locking frames of the covers with locking pawls as the engaging portions.

Although the vehicle body attaching brackets in the prior art project from the casing body inferior to chemical resistance, the vehicle body attaching brackets in the present invention project from the exteriors of the peripheral walls of one of or both of the upper and lower covers superior to chemical resistance. Accordingly, it is possible to freely select the attaching position of the electrical junction box in accordance with the layout in the vehicle body without causing any limitation of the attaching position.

Furthermore, as described above, since one of or both of the upper and lower covers is or are provided with a wire harness inserting portion for a wire harness to be connected to the interior circuit members in the casing body, it is possible to draw the wire harness into the electrical junction box without exposing the casing body to the outside and to readily connect the wire harness to the interior circuit members in the casing body.

In particular, preferably, the vehicle body attaching brackets project from each of the upper and lower covers so that the brackets are superimposed on each other. The brackets are provided with bolt holes. The bolt holes in the brackets are communicated with each other when the brackets are superimposed on each other. A bolt shank is inserted into the bolt holes from the upper cover to the lower cover. The brackets are secured to a vehicle body attaching members by bolts.

As described above, since the vehicle body attaching brackets projecting from both of the upper and lower covers are superimposed on each other and secured to the vehicle body attaching members by the bolts, it is possible to enhance strength of portions connected between the vehicle body and the electrical junction box.

Preferably, the bolt hole in the upper cover includes an upper end opening and a lower end opening in a bolt inserting direction. The upper end opening is a perfect circle. At least a portion of an inner peripheral surface of the bolt hole is enlarged slant, downward so that an area of the lower end opening is greater than that of the upper end opening. The bolt hole in the lower cover includes an upper end opening and a lower end opening in the bolt inserting direction. The lower end opening in the lower cover is the same perfect circle as that of the upper end opening in the upper cover. At least a portion of an inner peripheral surface of the bolt hole in the lower cover is enlarged slant, upward so that an area of the upper end opening in the lower cover is greater than that of the lower end opening in the lower cover and so that a peripheral edge of the upper end opening in the lower cover accords with or widens over a peripheral edge of the lower end opening of the bolt hole in the upper cover. A straight bolt inserting space is defined in the bolt holes in the bolt inserting direction when the lower end opening of the bolt hole in the upper cover and the upper end opening of the bolt hole in the lower cover are communicated with each other.

The brackets of the upper and lower covers are resin-molding products formed by injecting a resin material into a mold.

Upon injection molding, if the brackets are inclined and the brackets are provided with perfect through-holes extending in parallel with the inclined angle of the brackets, the through-holes will be formed into undercut configurations and the mold will be required for a sliding type of upper and lower mold members. This will require a complicated structure of the mold and will increase a cost in production.

On the contrary to the above problem, since the through-holes or the bolt holes in the present invention are the configuration in which the upper and lower mold members are widened in their removing directions and the undercut are not caused, that is, the configuration in which the through-hole or the bolt hole in the upper cover includes the upper end opening having the perfect circle and the lower end opening enlarged downward from the upper end opening and in which the through-hole or the bolt hole in the lower cover includes the lower end opening having the perfect circle and the upper end opening enlarged upward from the lower end opening, it is possible to readily form the upper and lower covers by the upper and lower mold members without using the sliding type of mold.

Accordingly, as described above, the bolt hole is formed in the upper cover so that the upper end opening of the bolt hole in the bolt inserting direction is the perfect circle and the lower end opening is widened more than the upper end opening while the bolt hole is formed in the lower cover so that the lower end opening of the bolt hole in the bolt inserting direction is the same perfect circle as the upper end opening of the upper cover and the upper end opening is widened more than the upper end opening. These bolt holes are communicated with each other.

According to the above configurations, even if the bolt shank is inserted into the perfect circular upper end opening in a slant position, the bolt shank is eventually guided into the perfect circular lower end opening. This will make it possible to fasten the bolt to the attaching surface of the vehicle body side in the vertical direction.

That is, merely by assembling the bolt holes, which can be easily formed by the upper and lower mold members, in the vertical direction, one bolt hole including the perfect circular upper end opening and the lower end opening enlarged more than the upper end opening, the other bolt hole including the perfect circular lower end opening and the upper end opening enlarged more than the lower end opening, the bolt can be straightly guided to a nut on the vehicle body attaching side, thereby preventing the bolt from being fastened in a slant position.

At this time, as described above, since the peripheral edge of the upper end opening of the bolt hole in the lower cover is accorded with or widened over the peripheral edge of the lower end opening of the bolt hole in the upper cover, it is possible to prevent an inner peripheral surface of the bolt hole in the lower cover from interfering with the bolt, even if the bolt is inserted into the bolt hole in the upper cover in a slant position. Accordingly, it is possible to smoothly move the bolt into the lower end opening of the bolt hole in the lower cover.

Particularly, since the portions of the inner peripheral surfaces of the bolt holes in the upper and lower covers are continued straightly in the bolt inserting direction, the bolt can be smoothly guided into the lower end opening of the bolt hole in the lower cover while the bolt is being moved onto the straight inner peripheral portions.

Preferably, the brackets project from the exteriors of peripheral walls of the upper and lower covers, and are formed into L-shaped configurations. Each of the brackets includes a lateral frame portion projecting from the exterior of the peripheral wall of each of the brackets and a longitudinal frame portion extending perpendicularly from a distal end of the lateral frame portion so that the longitudinal frame portion is arranged in a slant position. Each of the bolt holes is provided in each of the longitudinal frame portions. The brackets of the upper cover are mounted on upper surfaces of the brackets of the lower cover to assemble the brackets.

As described above, since the brackets that extend from the exteriors of the peripheral walls of the lower and upper covers are formed into the slant L-shaped configurations including the lateral frame portions and longitudinal frame portions, it is possible to steady dispose the brackets of the upper cover on the upper surfaces of the brackets of the lower cover. This will enhance strength of the portions connected between the vehicle body and the attaching members.

It is also possible to make the inserting direction of the bolt convenient for a working person by forming the longitudinal frame portions provided with the bolt holes in the slant positions with respect to the exteriors of the peripheral walls of the upper and lower covers. This will also enhance workability in insertion of the bolt.

Furthermore, as described above, since the brackets of the upper cover are mounted on the upper surfaces of the brackets of the lower cover, it is possible to readily carry out a work of inserting the bolt into the bolt holes.

It is preferable that the brackets of the upper and lower covers project at a given position from the respective covers so that the mounting step can be completed simultaneously with the time when the engaging portions of the casing body lock the portions being engaged of the upper and lower covers.

### [Effects of the Invention]

As described above, according to the present invention, since the upper and lower covers enclose the whole exterior of the casing body that contains the interior circuit members, it is possible to protect the casing body from being corroded by chemicals such as battery electrolyte, thereby obtaining the electrical junction box having superior chemical resistance.

Since the vehicle body attaching brackets project from the exteriors of the peripheral walls of one of or both of the upper and lower covers superior to chemical resistance, it is possible to freely select the attaching position of the electrical junction box in accordance with the layout in the vehicle body without causing any limitation of the attaching position.

In particular, since the brackets for vehicle body attachment project from both of the upper and lower covers, are superimposed on each other, and are secured to the vehicle body attaching members by the bolts, it is possible to enhance strength of portions connected between the vehicle body and the electrical junction box.

In addition, the brackets that extend from the upper and lower covers are superimposed on each other and the bolt holes are communicated with each other. The upper end opening and lower end opening are formed in each bolt hole in the upper cover. The upper end opening having a perfect circle receives a distal end of the bolt shank. The lower end opening having an imperfect circle is formed by downward enlarging a diameter of a part of the upper end opening. Each bolt hole in the lower cover includes the lower end opening having the same perfect circle as the upper end opening in the upper cover and the upper end opening having an imperfect circle. The upper end opening is formed by upward enlarging a diameter of a part of the lower end opening. The bolt shank is inserted into the upper end opening having the perfect circle in the upper cover and the bolt shank is eventually guided into the lower end opening having the perfect circle in the lower cover. Consequently, it is possible to position the bolt so that the bolt can be fastened in perpendicular to an attaching surface. That is, according to the above structure, only a pair of upper and lower mold members can form the bolt holes in the brackets so that the upper bolt hole is provided with the upper end opening having the perfect circle and the lower end opening enlarged downward from the upper end opening and the lower bolt hole is provided with the lower end opening having the perfect circle and the upper end opening enlarged upward from the lower end opening. It is possible to effectively prevent the bolt from being fastened in a slant position merely by combining the upper and lower bolt holes in the vertical direction.

As described above, since the brackets that extend from the exteriors of the peripheral walls of the lower and upper covers are formed into the slant L-shaped configurations including the lateral frame portions and longitudinal frame portions, it is possible to steady mount the brackets of the upper cover on the upper surfaces of the brackets of the lower cover. This will enhance workability in insertion of the bolt and strength of the portions connected between the vehicle body and the attaching members.

It is also possible to make the inserting direction of the bolt convenient for a working person by forming the longitudinal frame portions provided with the bolt holes in the slant positions with respect to the exteriors of the peripheral walls of the upper and lower covers. This will also enhance workability in insertion of the bolt.

### [Brief Explanation of the Drawings]

Figure 1 is a schematically perspective view of an electrical junction box to be mounted on a motor vehicle in accordance with the present invention.
Figure 2 is an exploded side elevation view of the electrical junction box of the present invention. Figure 2A is a side elevation view of an upper cover. Figure 2B is a side elevation view of a casing body. Figure 2C is a side elevation view of a lower cover.
Figure 3A is a side elevation view of the electrical junction box of the present invention. Figure 3B is a sectional view of a main part of the lower cover, illustrating a relationship between a locking frame of the lower cover and a locking pawl of the casing body. Figure 3C is a sectional view of a main part of the lower cover, illustrating an alteration of the relationship shown in Fig. 3B.
Figure 4A is a plan view of a top side (upper end opening side) of the upper cover. Figure 4B is a plan view of a bottom side (lower end opening side) of the upper cover.
Figure 5 is a plan view of a top side of the casing body.
Figure 6A is a plan view of a top side (upper end opening side) of the lower cover. Figure 6B is a plan view of a bottom side (lower end opening side) of the lower cover.
Figure 7A is a sectional view of brackets, illustrating a position where an upper cover side bracket is fitted on a lower cover side bracket. Figure 7B is a sectional view of the brackets secured to a vehicle body attaching members by a bolt.
Figure 8 is an enlarged side elevation view of a main part of the upper cover, lower cover, and casing body, illustrating a relationship among the locking frames of the upper and lower covers and the locking pawls of the casing body.
Figures 9A and 9B are sectional views of the brackets of the upper and lower covers, illustrating alterations of bolt holes in the brackets.
Figure 10 is an exploded side elevation view of a prior art electrical junction box to be mounted on a motor vehicle.

### [Preferred Aspects of Embodying the Invention]

Embodiments of an electrical junction box to be mounted on a motor vehicle in accordance with the present invention will be described below by referring to the drawings.

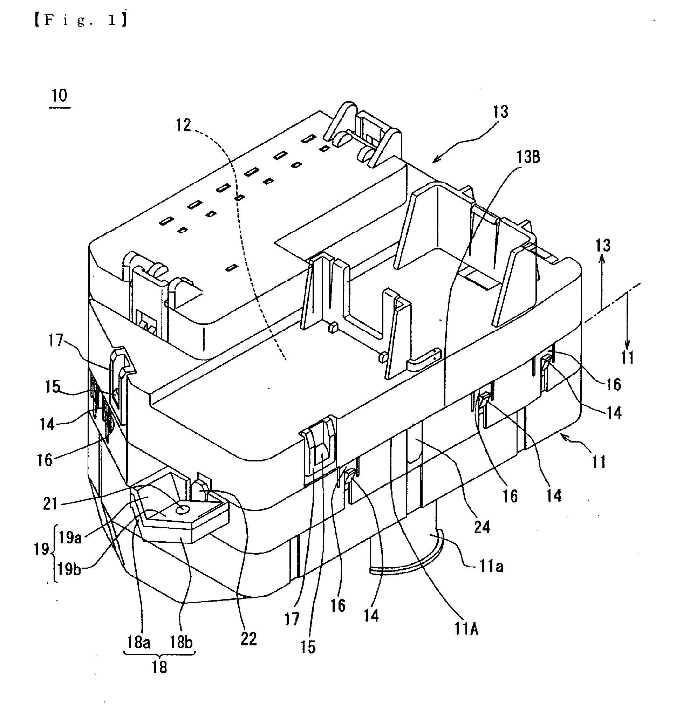

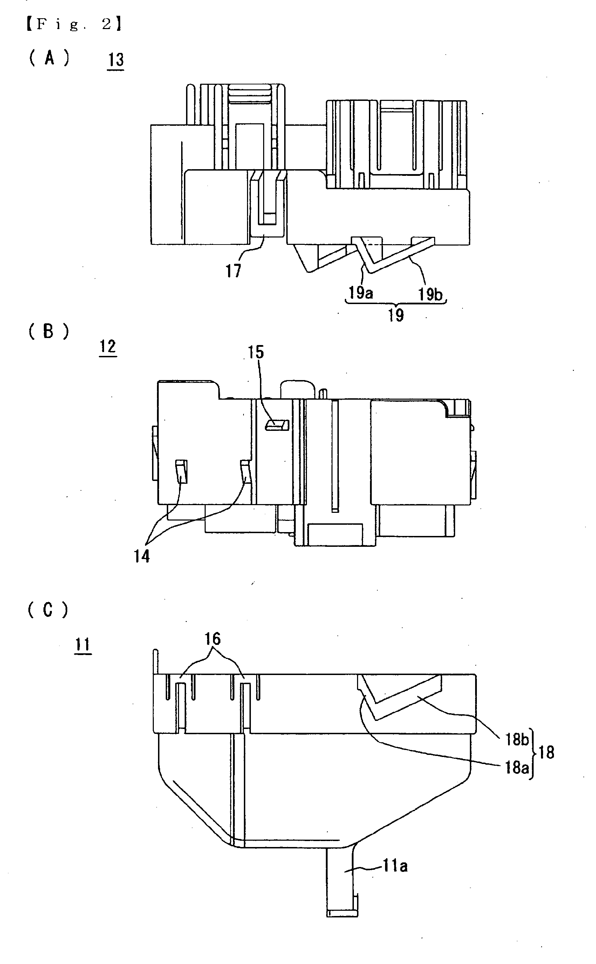

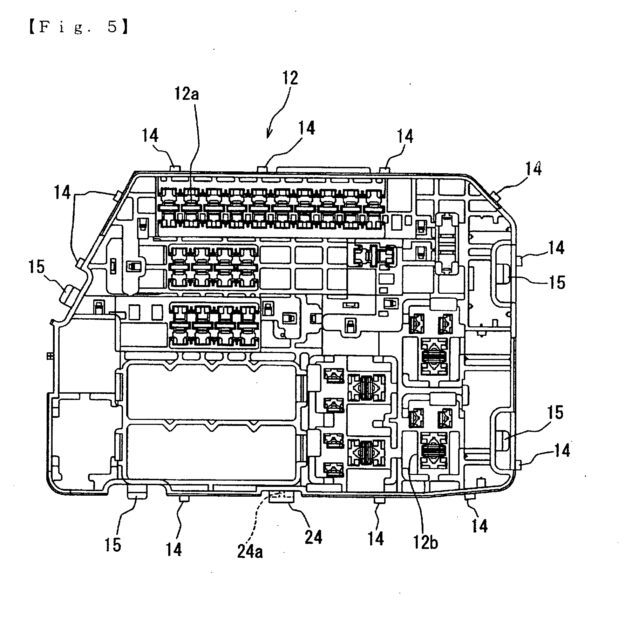

Figures 1 to 8 show an embodiment of an electrical junction box to be mounted on a motor vehicle in accordance with the present invention.

An electrical junction box 10 to be mounted on a motor vehicle includes a lower cover 11, a casing body 12, and an upper cover 13. The lower cover 11 and upper cover 13 enclose the whole exterior of the casing body 12 to contain it therein.

The casing body 12 contains interior circuit members such as bus bars (not shown) and the like. The casing body 12 is provided on a top side with fuse mounting sections 12a and relay mounting sections 12b.

The casing body 12 is made of a polymer alloy resin including a polyamide 66 (PA66) and a polyphenylene ether (PPE) that are superior to heat resistance. On the other hand, the upper and lower covers 13 and 11 are made of a polypropylene terephthalate (PPT) resin that is superior to chemical resistance.

The lower cover 11 is provided with an inserting section 11a for a wire harness to be connected to the interior circuit members of the casing body 12.

The lower cover 11 is provided on a peripheral wall with a plurality of locking frames 16 (eleven frames in this embodiment) that engage locking pawls 14 provided on an exterior of a peripheral wall of the casing body 12. Also, the upper cover 13 is provided on a peripheral wall with a plurality of locking frames 17 (four frames in this embodiment) that engage locking pawls 15 provided on an exterior of a peripheral wall of the casing body 12.

The locking pawls 14 and 15 serve as engaging portions while the locking frames 16 and 17 serve as portions being engaged.

The lower cover 11 is coupled upward to a lower part of the casing body 12 while the upper cover 13 is coupled downward to an upper part of the casing body 12. When the locking pawls 14 of the casing body 12 engage the locking frames 16 (portions being engaged) of the lower cover 11 and the locking pawls 15 of the casing body 12 engage the locking frames 17 (portions being engaged) of the lower cover 11, a lower end 13B of the upper cover 13 contacts an upper end 11A of the upper cover 11 so that the peripheral walls of the upper and lower covers 13 and 11 are aligned on the same plane. Consequently, the casing body 12 is enclosed by the upper and lower covers 13 and 11.

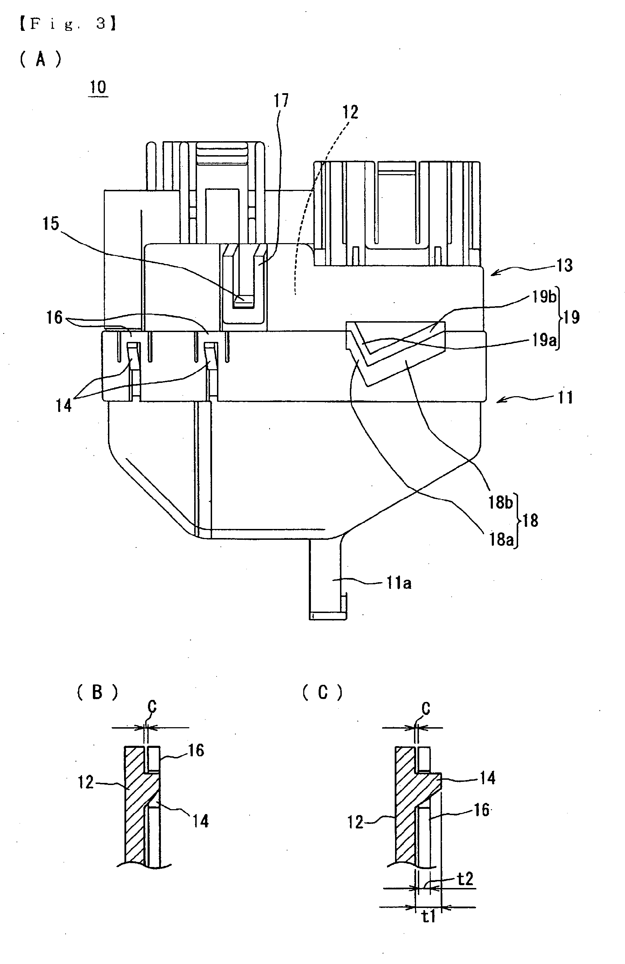

In more detail, when the locking pawls 14 of the casing body 12 engage the locking frames 16 of the lower cover 11, a clearance C is defined between the locking frames 16 and the casing body 12, as shown in Fig. 3B. The clearance C is set in accordance with coefficients of thermal expansion of the lower cover 11 and casing body 12 that are resin-molding products, when the covers 11 and 13 are expanded by heating. Consequently, they do not interfere with each other upon thermal expansion.

Although as shown in Fig. 3B, the locking pawls 14 engage the whole engaging surfaces of the locking frames 16 so that the locking pawls 14 do not project from the locking frames 16, a thickness t1 of each locking pawl 14 may be set to be greater than a thickness t2 of each locking frame 16 so that the locking pawl 14 projects from the locking frame 16 slightly, as shown in Fig. 3C. That is, the locking pawls 14 project from the locking frames 16 so that the locking pawls 14 do not come out of the locking frames 16 easily.

A relationship between the locking pawls 14 of the casing body 12 and the locking frames 17 of the upper cover 13 is the same as that between the locking pawls 14 of the casing body 12 and the locking frames 16 of the lower cover 11.

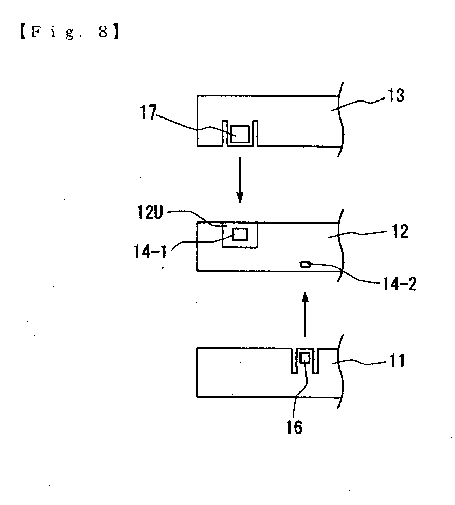

In more detail, as shown in Fig. 8, each locking frame 17 is formed by cutting a part of the lower end 13B of the upper cover 13. On the other hand, the casing body 12 is provided on the exterior of the peripheral wall with recesses 12U that receive the locking frames 17. Locking pawls 14-1 are provided on the exterior of the peripheral wall of the casing body 12 so that each locking pawl 14-1 is disposed on a central part of each recess 12U. An amount of projecting each locking pawl 14 is the same as a thickness of each locking frame 17 that engages each recess 12U.

Thus, when the locking pawls 14 of the casing body 12 engage the locking frames 17 of the upper cover 13, their engaging portions do not project from the exterior of the upper cover 13.

Although locking pawls 14-2 of the casing body 12 that engage the locking frames 16 of the lower cover 11 project from a flat exterior of the casing body 12, the locking pawls 14-2 may be formed into the same configurations of the upper cover side.

Lower and upper brackets 18 and 19 for attaching to a vehicle body are provided on a pair of opposite exteriors of the peripheral walls of the lower and upper covers 11 and 13, respectively. The upper brackets 19 of the upper cover 13 are superimposed on the lower brackets 18 of the lower cover 11 when they are assembled.

Each bracket 18 of the lower cover 11 is formed into an L-shaped configuration when seen from the respective side of the junction box 10, including a lateral frame portion 18a projecting perpendicularly from the exterior of the peripheral wall of the lower cover 11 and a longitudinal frame portion 18b extending perpendicularly from a distal end of the lateral frame portion 18a and also projecting perpendicularly relative to the exterior of the peripheral wall of the lower cover 11. Each bracket 19 of the upper cover 13 is formed into an L-shaped configuration including a lateral frame portion 19a projecting perpendicularly from the exterior of the peripheral wall of the upper cover 13 and a longitudinal frame portion 19b extending perpendicularly from a distal end of the lateral frame portion 19a and projecting also perpendicularly relative to the exterior of the peripheral wall of the upper cover 13. The longitudinal frame portions 18b and 19b are provided with bolt holes 20 and 21, respectively. When the brackets 19 are put on the brackets 18, the bolt holes 21 and 20 are communicated with each other.

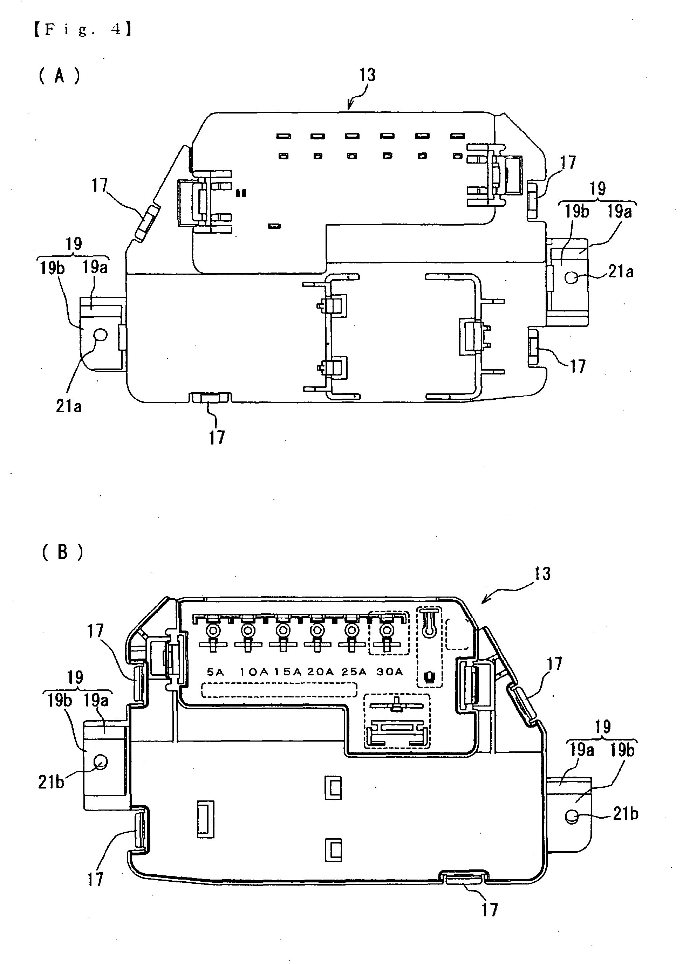

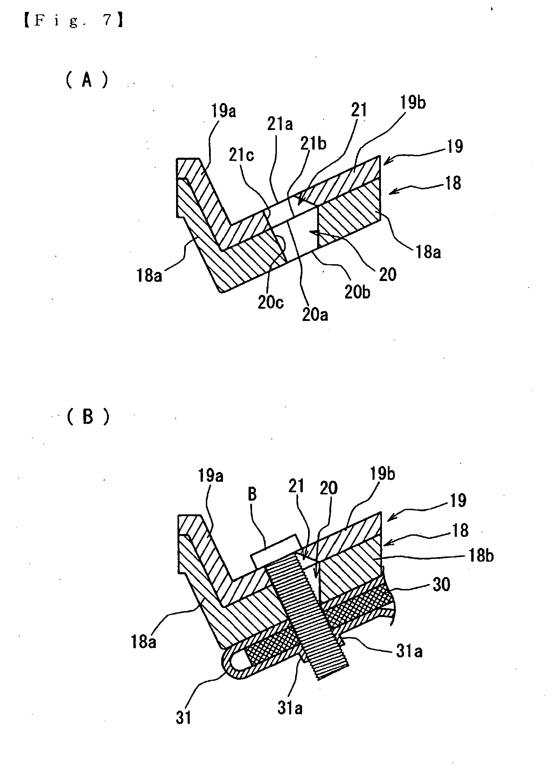

As shown in Figures 4 and 7, the bolt hole 21 in the upper cover 13 includes an upper end opening 21 a having a perfect circle and a lower end opening 21 b having an imperfect circle. The lower end opening 21 b is formed by downward enlarging a diameter of a part of the upper end opening 21a so that the lower end opening 21 b defines a greater area than the upper end opening 21a.

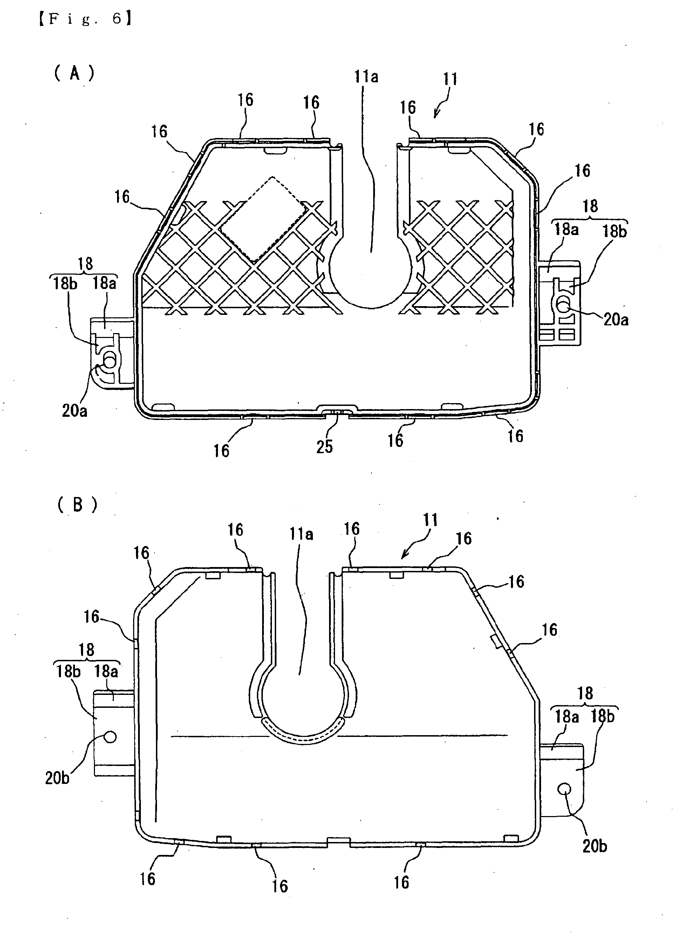

Also, as shown in Figures 6 and 7, the bolt hole 20 in the lower cover 11 includes a lower end opening 20b having a perfect circle and an upper end opening 20a having an imperfect circle. The upper end opening 20a is formed by upward enlarging a diameter of a part of the lower end opening 20b so that the upper end opening 20a defines a greater area than the lower end opening 20b. Furthermore, a peripheral edge of the upper end opening 20a accords with a peripheral edge of the lower end opening 21b of the bolt hole 21 in the upper cover 13. Portions 21 c and 20c of inner peripheral surfaces of the bolt holes 21 and 20 in the upper cover 13 and lower cover 11 are continued straightly along an axial direction of a bolt B or a direction of fastening the bolt B.

The locking pawls 14 of the casing body 12 engage the locking frames 16 of the lower cover 11 while the locking pawls 15 of the casing body 12 engage the locking frames 17 of the upper cover 13. The brackets 19 of the upper cover 13 are disposed on upper surfaces of the brackets 18 of the lower cover 11. Under this condition, a shank of the bolt B is inserted into the communicated bolt holes 20 and 21 and the brackets 18 and 19 are secured to a vehicle body attaching members 30 by fastening the bolt B.

Although the brackets 18 and 19 are secured to the vehicle body attaching members 30 by means of a bolt and a nut, for example, a clip (stay) 31 may be utilized, as shown in Fig. 7B.

The clip 31 clamps the vehicle body attaching members 30 so that their bolt holes are communicated with each other. The superimposed brackets 18 and 19 are disposed on a top side of the clip 31 and the bolt B is inserted into the bolt hole 21 in the bracket 19 of the upper cover 13 and screwed into the bolt holes in the bracket 18, clip 31, and member 30. At this time, since an engaging piece 31 a on a rear side of the clip 31 engages threads on the bolt B that passes the bolt hole in the rear side of the clip 31, it is possible to readily finish a step of attaching the brackets 18 and 19 to the vehicle body without using a nut.

As described above, in the electrical junction box 10 of the present invention, since the upper and lower covers 13 and 11 enclose the whole exterior of the casing body 12 and contain the casing body 12, it is possible to protect the casing body 12 from being corroded by chemicals such as battery electrolyte, thereby obtaining the electrical junction box having high chemical resistance.

Also, since the brackets 18 and 19 extend from the exteriors of the lower cover 11 and upper cover 13 that have chemical resistance, it is possible to freely select an attaching position in accordance with a layout in the vehicle body without restraining an attaching position of the electrical junction box 10. Furthermore, since the brackets 18 and 19 extend from the exteriors of the lower cover 11 and upper cover 13 and they are superimposed on and secured to each other by the bolt B, it is possible to enhance strength of portions connected between the vehicle body and the electrical junction box 10.

In addition, the brackets 18, 19 that extend from the upper and lower covers 13 and 11 are superimposed on each other and the bolt holes 21 and 20 are communicated with each other. As described above, the upper end opening 21 a and lower end opening 21 b are formed in each bolt hole 21 of the upper cover 13. The upper end opening 21 a having a perfect circle receives a distal end of the bolt shank. The lower end opening 21b having an imperfect circle is formed by downward enlarging a diameter of a part of the upper end opening 21 a. Each bolt hole 20 in the lower cover 11 includes the lower end opening 20b having a perfect circle and the upper end opening 20a having an imperfect circle. The upper end opening 20a is formed by upward enlarging a diameter of a part of the lower end opening 20b. The bolt B is inserted into the upper end opening 21 a having the perfect circle in the upper cover 13 and the bolt shank is eventually guided into the lower end opening 20b having the perfect circle in the lower cover 11. Consequently, it is possible to position the bolt B so that the bolt B can be fastened in perpendicular to an attaching surface. That is, according to the above structure, only a pair of upper and lower mold members can form the bolt holes 20 and 21 in the brackets 18 and 19 so that each upper bolt hole 21 is provided with the upper end opening 21 a having the perfect circle and the lower end opening 21 b enlarged downward from the upper end opening 21 a and each lower bolt hole 20 is provided with the lower end opening 20b having the perfect circle and the upper end opening 20a enlarged upward from the lower end opening 20b. It is possible to effectively prevent the bolt B from being fastened in a slant position merely by combining the upper and lower bolt holes 21 and 20 in the vertical direction.

As described above, since the peripheral edge of the upper end opening 20a of the bolt hole 20 in the lower cover 11 accords with the peripheral edge of the lower end opening 21 a of the bolt hole 21 in the upper cover 13, an inner peripheral surface of the bolt hole 20 in the lower cover 11 does not interferes with the bolt B, even if the bolt B is inserted into the bolt hole 21 in the upper cover 13 in a slant position. Accordingly, it is possible to smoothly move the bolt B into the lower end opening 20b of the bolt hole 20 in the lower cover 11.

As described above, since the portions 21c and 20c of the inner peripheral surfaces of the bolt holes 21 and 20 in the upper and lower covers 13 and 11 are continued straightly in the bolt inserting direction, the bolt B can be smoothly guided into the lower end opening 20b of the bolt hole 20 in the lower cover 11 while the bolt B is being moved onto the straight inner peripheral portions 21c and 20c.

As described above, since the brackets 18 and 19 that extend from the exteriors of the peripheral walls of the lower and upper covers 11 and 13 are formed into the L-shaped configurations including the lateral frame portions 18a and 19a and longitudinal frame portions 18b and 19b, it is possible to steady mount the brackets 19 of the upper cover 13 on the upper surfaces of the brackets 18 of the lower cover 11. This will enhance workability in insertion of the bolt and strength of the portions connected between the vehicle body and the attaching members.

It is also possible to make the inserting direction of the bolt convenient for a working person by forming the longitudinal frame portions 18b and 19b provided with the bolt holes 20 and 21 in the most convenient positions with respect to the exteriors of the peripheral walls of the upper and lower covers 13 and 11. This will also enhance workability in insertion of the bolt.

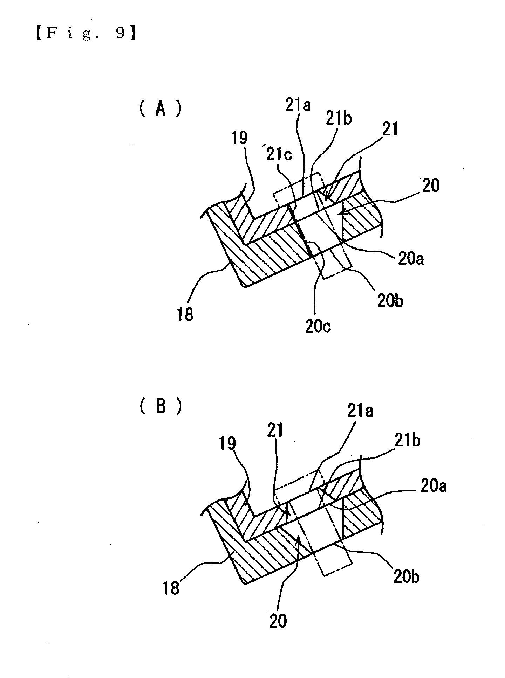

The present invention is not limited to the embodiments described above. The bolt holes 20 and 21 in the brackets 18 and 19 of the lower and upper covers 11 and 13 may be configurations shown in Figures 9A and 9B.

The configurations of the bolt holes 20 and 21 shown in Fig. 9A are different from those of the bolt holes 20 and 21 shown in Fig. 7A with respect to the fact that the upper end opening 20a of the bolt hole 20 in the lower cover 11 is enlarged rather than the lower end opening 21 b of the bolt hole 21 in the upper cover 13. However, the lower end opening 20b of the bolt hole 20 and the upper end opening 21 a of the bolt hole 21 are the same configurations and the center of the openings accord with the central axis of the bolt B.

The portions 21 c and 20c of the inner peripheral surfaces of the bolt holes 21 and 20 are continued straightly, as in the case shown in Fig. 7A. However, the peripheral edge of the upper end opening 20a of the bolt hole 20 in the lower cover 11 is widened outward at the opposed side in a diametric direction from the peripheral edge of the lower end opening 21 b of the bolt hole 21.

Although the bolt holes 20 and 21 have such configurations, it is possible to surely define a space that enable the bolt B to move from the bolt hole 21 in the inserting direction, thereby advancing the bolt B straightly in the inserting direction.

In configurations of the bolt holes 20 and 21 shown in Fig. 9B, as in the case shown in Fig. 9A, the upper end opening 20a of the bolt hole 20 in the lower cover 11 is enlarged more than the lower end opening 21 b of the bolt hole 21 in the upper cover 13 and the whole peripheral edge of the upper end opening 20a is disposed in the diametric direction over the whole peripheral edge of the lower end opening 21b of the bolt hole 21 in the upper cover 13.

In the configurations shown in Fig. 9B, the lower end opening 20b of the bolt hole 20 is the same as the upper end opening 21 a of the bolt hole 21 and the openings 20b and 21 a are coaxial with the axis of the bolt B.

Although the bolt holes 20 and 21 have such configurations, it is possible to surely define a space that enable the bolt B to move from the bolt hole 21 in the inserting direction, thereby advancing the bolt B straightly in the inserting direction.

## Claims

1. An electrical junction box (10) to be mounted on a motor vehicle, including a casing body (12) that contains interior circuit members, an upper cover (13), and a lower cover (11),
wherein vehicle body attaching brackets (18, 19) are provided on at least one of said upper and lower covers (13, 11);
wherein said casing body (12) is provided on an exterior with engaging portions (14, 15) and at least one of said upper and lower covers (13, 11) is provided on the peripheral walls thereof with portions (16, 17) being engaged that are locked with said engaging portions (14, 15); and
wherein, when said engaging portions (14, 15) lock said portions (16, 17) being engaged, said upper cover (13) is coupled to said lower cover (11) and said upper and lower covers (13, 11) enclose said casing body (12),
**characterized in that**
furthermore, when said engaging portions (14, 15) lock said portions (16, 17) being engaged, a lower end (13B) of said upper cover (13) contacts an upper end (11A) of said lower cover (11), so that peripheral walls of upper (13) and lower cover (11) are aligned in the plane of a common surface; and
said engaging portions (14, 15) and said portions (16, 17) being engaged are provided such as not to project from said plane.

2. An electrical junction box (10) to be mounted on a motor vehicle, according to Claim 1, wherein said vehicle body attaching brackets (18, 19) project from each of said upper and lower covers (13, 11) as upper (18) and lower brackets (19), respectively, so that said brackets (18, 19) are superimposed on each other when said upper and lower covers (13, 11) enclose said casing body (12), said brackets (18, 19) are provided with bolt holes (20, 21), said bolt holes (20, 21) are communicated with each other when said brackets (18, 19) are superimposed on each other, wherein a bolt shank of a bolt (B) is insertable into said communicating bolt holes (20, 21) in a direction from one of said covers to the other one for securing said superimposed brackets (18, 19) to a vehicle body attaching member (30) by said bolt (B).

3. An electrical junction box (10) to be mounted on a motor vehicle, according to Claim 2, wherein
said bolt hole (21) in said upper bracket (19) includes an upper end opening (21 a) and a lower end opening (21 b) in a bolt inserting direction, said upper end opening (21a) is a perfect circle, at least a portion of an inner peripheral surface of said bolt hole is enlarged slanting downward so that an area of said lower end opening (21 b) is greater than that of said upper end opening (21a);
said bolt hole (20) in said lower bracket (18) includes an upper end opening (20a) and a lower end opening (20b) in said bolt inserting direction, said lower end opening (20b) in said lower bracket (18) is the same perfect circle as that of said upper end opening (21 a) in said upper bracket (19), at least a portion of an inner peripheral surface of said bolt hole (20) in said lower bracket (18) is enlarged slanting upward so that an area of said upper end opening (20a) in said lower bracket (18) is greater than that of said lower end opening (20b) in said lower bracket (18) and so that a peripheral edge of said upper end opening (20a) in said lower bracket (18) accords with or widens over a peripheral edge of said lower end opening (21b) of said bolt hole in said upper bracket (19); and
a straight bolt inserting space is defined in said bolt holes (20, 21) in said bolt inserting direction when said lower end opening (21 b) of said bolt hole in said upper bracket (19) and said upper end opening (20a) of said bolt hole in said lower bracket (18) are communicated with each other.

4. An electrical junction box (10) to be mounted on a motor vehicle, according to Claim 2 or 3, wherein
said brackets (18, 19) project from the exteriors of peripheral walls of said lower and upper covers (11, 13), and are formed into L-shaped configurations when seen from the respective side of the electrical junction box (10), said L-shape having a lateral frame portion (18a, 19a) and a longitudinal frame portion (18b, 19b) extending perpendicularly from a distal end of said lateral frame portion (18a, 19a), both frame portions (18a, 19a, 18b, 19b) project perpendicularly from the exterior of said peripheral wall of each of said covers (13, 11) and both frame portions (18a, 19a, 18b, 19b) are arranged in a slanted position such that in assembling said brackets (18, 19) a steady mounting of upper bracket (19) on an upper surface of a corresponding lower bracket (18) is possible; and
each of said bolt holes (20, 21) is provided in each of said longitudinal frame portions (18b, 19b).

## Patentansprüche

1. Ein Elektroanschlusskasten (10) zur Montage an einem Kraftfahrzeug, enthaltend einen Kastenkörper (12), der innere Schaltungsteile enthält, eine obere Abdeckung (13) und eine untere Abdeckung (11), wobei
Fahrzeugkarosseriebefestigungsklammern (18, 19) an wenigstens entweder der oberen oder der unteren Abdeckung (13, 11) angeordnet sind;
der Kastenkörper (12) an einem Äußeren mit Eingriffsabschnitten (14, 15) versehen ist und wenigstens entweder die obere oder die untere Abdeckung (13, 11) an Umfangswänden hiervon mit zu ergreifenden Abschnitten (16, 17) versehen ist, welche mit den Eingriffsabschnitten (14, 15) verriegelt werden; und
wobei, wenn die Eingriffsabschnitte (14, 15) die zu ergreifenden Abschnitte (16, 17) verriegeln, die obere Abdeckung (13) mit der unteren Abdeckung (11) verbunden ist und die oberen und unteren Abdeckungen (13, 11) den Kastenkörper (12) umschließen,
**dadurch gekennzeichnet, dass**
weiterhin, wenn die Eingriffsabschnitte (14, 15) die zu ergreifenden Abschnitte (16, 17) verriegeln, ein unteres Ende (13B) der oberen Abdeckung (13) ein oberes Ende (11A) der unteren Abdeckung (11) berührt, sodass Umfangswände von oberer (13) und unterer Abdeckung (11) in der Ebene einer gemeinsamen Oberfläche ausgerichtet sind; und
die Eingriffsabschnitte (14, 15) und die zu ergreifenden Abschnitte (16, 17) so angeordnet sind, dass sie nicht von dieser Ebene vorstehen.

2. Ein Elektroanschlusskasten (10) zur Montage an einem Kraftfahrzeug, nach Anspruch 1, wobei die Fahrzeugkarosseriebefestigungsklammern (18, 19) von jeder der oberen und unteren Abdeckung (13, 11) als obere (18) bzw. unter Klammern (19) vorstehen, sodass die Klammern (18, 19) einander überlagern, wenn die obere und untere Abdeckung (13, 11) den Kastenkörper (12) umschließen, wobei die Klammern (18, 19) mit Bolzenöffnungen (20, 21) versehen sind, wobei diese Bolzenöffnungen (20, 21) miteinander in Verbindung stehen, wenn die Klammern (18, 19) übereinander liegen, wobei ein Bolzenschaft eines Bolzens (B) in den in Verbindung stehenden Bolzenöffnungen (20, 21) in einer Richtung von einer der Abdeckungen zu der anderen hin einführbar ist, um die übereinanderliegenden Klammern (18, 19) mittels des Bolzens (B) an einem Fahrzeugkarosserieanbauteil (30) festzulegen.

3. Ein Elektroanschlusskasten (10) zur Montage an einem Kraftfahrzeug, nach Anspruch 2, wobei
die Bolzenöffnung (21) in der oberen Klammer (19) in Bolzeinführrichtung eine Oberendenöffnung (21a) und eine Unterendenöffnung (21b) enthält, wobei die Oberendenöffnung (21a) ein perfekter Kreis ist, wenigstens ein Abschnitt einer inneren Umfangsoberfläche der Bolzenöffnung sich schräg nach unten vergrößernd ist, sodass eine Fläche der Unterendenöffnung (21 b) größer als diejenige der Oberendenöffnung (21a) ist; die Bolzenöffnung (20 in der unteren Klammer (18) eine Oberendenöffnung (20a) und eine Unterendenöffnung (20b) in der Bolzeneinführrichtung aufweist, wobei die Unterendenöffnung (20b) der unteren Klammer (18) der gleiche perfekte Kreis wie bei der Oberendenöffnung (21a) der oberen Klammer (19) ist, wobei wenigstens ein Abschnitt einer inneren Umfangsoberfläche der Bolzenöffnung (20) in der unteren Klammer (18) sich schräg nach oben vergrößert, sodass eine Fläche der Oberendenöffnung (20a) in der unteren Klammer (18) größer als die der Unterendenöffnung (20b) in der unteren Klammer (18) ist, sodass eine Umfangskante der Oberendenöffnung (20a) in der unteren Klammer (18) in Übereinstimmung ist mit oder über eine Umfangskante der Unterendenöffnung (21 b) der Bolzenöffnung in der oberen Klammer (19) hinausläuft; und
ein gerader Bolzeneinführraum in den Bolzenöffnungen (20, 21) in Bolzeneinführrichtung definiert ist, wenn die Unterendenöffnung (21b) der Bolzenöffnung in der oberen Klammer (19) und die Oberendenöffnung (20a) der Bolzenöffnung in der Unterseitenklammer (18) in Verbindung miteinander sind.

4. Ein Elektroanschlusskasten (10) zur Montage an einem Kraftfahrzeug, nach Anspruch 2 oder 3, wobei
die Klammern (18, 19) vom Äußeren der Umfangswände der unteren und oberen Abdeckungen (11, 13) vorstehen und von der entsprechenden Seite des Elektroanschlusskastens (10) hergesehen L-förmige Ausgestaltungen haben, wobei die L-Form einen seitlichen Rahmenabschnitt (18a, 19a) und einen Längsrahmenabschnitt (18b, 19b) hat, der sich senkrecht von einem distalen Ende des Seitenrahmenabschnitts (18a, 19a) erstreckt, wobei beide Rahmenabschnitt (18a, 19a, 18b, 19b) sich senkrecht vom Äußeren der Umfangswand einer jeden der Abdeckungen (13, 11) erstrecken und beide Rahmenabschnitte (18a, 19a, 18b, 19b) in einer schrägen Position so angeordnet sind, dass beim Zusammenbau der Klammern (18, 19) eine stabile Anordnung der oberen Klammer (19) auf einer oberen Oberfläche einer entsprechenden unteren Klammer (18) möglich ist; und
jede der Bolzenöffnungen (20, 21) in jedem der Längsrahmenabschnitte (18b, 19b) angeordnet ist.

## Revendications

1. Boîte de raccordement électrique (10) à assembler sur un véhicule à moteur, comprenant un corps de carter (12) qui contient des éléments de circuit intérieurs, un couvercle supérieur (13), et un couvercle inférieur (11),
dans laquelle des supports de fixation de corps de véhicule (18, 19) sont disposés sur au moins l'un desdits couvercles supérieur et inférieur (13, 11) ;
dans laquelle ledit corps de carter (12) est disposé sur un extérieur avec des parties de mise en prise (14, 15) et au moins l'un desdits couvercles supérieur et inférieur (13, 11) est disposé sur les parois périphériques de celui-ci avec des parties (16, 17) mises en prise qui sont verrouillées avec lesdites parties de mise en prise (14, 15) ; et
dans laquelle, lorsque lesdites parties de mise en prise (14, 15) verrouillent lesdites parties (16, 17) mises en prise, ledit couvercle supérieur (13) est couplé au dit couvercle inférieur (11) et lesdits couvercles supérieur et inférieur (13, 11) enveloppent ledit corps de carter (12),
**caractérisée en ce que**
en outre, lorsque lesdites parties de mise en prise (14, 15) verrouillent lesdites parties (16, 17) mises en prise, une extrémité inférieure (13B) dudit couvercle supérieur (13) est en contact avec une extrémité supérieure (11A) dudit couvercle inférieur (11), de sorte que les parois périphériques du couvercle supérieur (13) et du couvercle inférieur (11) soient alignées dans le plan d'une surface commune ; et
lesdites parties de mise en prise (14, 15) et lesdites parties (16, 17) mises en prise sont disposées de manière à ne pas se projeter dudit plan.

2. Boîte de raccordement électrique (10) à assembler sur un véhicule à moteur selon la revendication 1, dans laquelle lesdits supports de fixation de corps de véhicule (18, 19) se projettent de chacun desdits couvercles supérieur et inférieur (13, 11) respectivement en tant que support supérieur (18) et support inférieur (19), de sorte que lesdits supports (18, 19) soient superposés l'un sur l'autre lorsque lesdits couvercles supérieur et inférieur (13, 11) enveloppent ledit corps de carter (12), lesdits supports (18, 19) sont pourvus de trous à boulon (20, 21), lesdits trous à boulon (20, 21) communiquent entre eux lorsque lesdits supports (18, 19) sont superposés l'un sur l'autre, dans laquelle une pointe de boulon d'un boulon (B) peut être insérée dans lesdits trous à boulon communicant (20, 21) dans une direction de l'un desdits couvercles à l'autre pour fixer lesdits supports superposés (18, 19) sur un élément de fixation de corps de véhicule (30) par ledit boulon (B).

3. Boîte de raccordement électrique (10) à assembler sur un véhicule à moteur selon la revendication 2, dans laquelle
ledit trou à boulon (21) dans ledit support supérieur (19) comprend une ouverture d'extrémité supérieure (21a) et une ouverture d'extrémité inférieure (21b) dans une direction d'insertion de boulon, ladite ouverture d'extrémité supérieure (21a) est un cercle parfait, au moins une partie d'une surface périphérique intérieure dudit trou à boulon s'élargit en inclinaison vers le bas de sorte qu'une surface de ladite ouverture d'extrémité inférieure (21b) soit supérieure à celle de ladite ouverture d'extrémité supérieure (21a) ;
ledit trou à boulon (20) dans ledit support inférieur (18) comprend une ouverture d'extrémité supérieure (20a) et une ouverture d'extrémité inférieure (20b) dans ladite direction d'insertion de boulon, ladite ouverture d'extrémité inférieure (20b) dans ledit support inférieur (18) est le même cercle parfait que celui de ladite ouverture d'extrémité supérieure (21a) dans ledit support supérieur (19), au moins une partie d'une surface périphérique intérieure dudit trou à boulon (20) dans ledit support inférieur (18) s'élargit en inclinaison vers le haut de sorte qu'une surface de ladite ouverture d'extrémité supérieure (20a) dans ledit support inférieur (18) soit supérieure à celle de ladite ouverture d'extrémité inférieure (20b) dans ledit support inférieur (18) et de sorte qu'un bord périphérique de ladite ouverture d'extrémité supérieure (20a) dans ledit support inférieur (18) s'accorde ou s'élargisse sur un bord périphérique de ladite ouverture d'extrémité inférieure (21b) dudit trou à boulon dans ledit support supérieur (19) ; et
un espace d'insertion de boulon droit est défini dans lesdits trous à boulon (20, 21) dans ladite direction d'insertion de boulon lorsque ladite ouverture d'extrémité inférieure (21b) dudit trou à boulon dans ledit support supérieur (19) et ladite ouverture d'extrémité supérieure (20a) dudit trou à boulon dans ledit support inférieur (18) sont en communication entre elles.

4. Boîte de raccordement électrique (10) à assembler sur un véhicule à moteur selon la revendication 2 ou 3, dans laquelle
lesdits supports (18, 19) se projettent des extérieurs des parois périphériques desdits couvercles inférieur et supérieur (11, 13) et sont formés dans des configurations en forme de L en vue du côté respectif de la boîte de raccordement électrique (10), ladite forme en L ayant une partie de cadre latérale (18a, 19a) et une partie de cadre longitudinale (18b, 19b) s'étendant perpendiculairement d'une extrémité distale de ladite partie de cadre latérale (18a, 19a), les deux parties de cadre (18a, 19a, 18b, 19b) se projettent perpendiculairement de l'extérieur de ladite paroi périphérique de chacun desdits couvercles (13, 11) et les deux parties de cadre (18a, 19a, 18b, 19b) sont disposées dans une position inclinée de sorte que, en assemblant lesdits supports (18, 19), un montage régulier du support supérieur (19) sur une surface supérieure d'un support inférieur correspondant (18) est possible ; et
chacun desdits trous à boulon (20, 21) est disposé dans chacune desdites parties de cadre longitudinales (18b, 19b).
